# EUROPÄISCHE PATENTSCHRIFT

(11) **EP 2 695 207 B1**
(45) Veröffentlichungstag und Bekanntmachung des Hinweises auf die Patenterteilung: **07.08.2019**
(21) Anmeldenummer: 12708853.2
(22) Anmeldetag: 15.03.2012
(51) Int. Cl.: H01L 33/44, H01L 33/40, H01L 33/54, H01L 33/38, H01L 33/22, H01L 33/00

(54) **OPTOELEKTRONISCHER HALBLEITERCHIP**
OPTOELECTRONIC SEMICONDUCTOR CHIP
PUCE SEMI-CONDUCTRICE OPTOÉLECTRONIQUE

(30) Priorität: 07.04.2011 DE 102011016302
(43) Veröffentlichungstag der Anmeldung: 12.02.2014
(73) Patentinhaber: OSRAM Opto Semiconductors GmbH, 93055 Regensburg (DE)
(72) Erfinder: HÖPPEL, Lutz, 93087 Alteglofsheim (DE)
(74) Vertreter: Epping - Hermann - Fischer
(86) Internationale Anmeldenummer: PCT/EP2012/054601
(87) Internationale Veröffentlichungsnummer: WO 2012/136460

(56) Entgegenhaltungen:
- WO-A1-2012/031852
- WO-A2-2009/061704
- DE-A1-102007 022 947
- DE-A1-102008 030 584
- DE-A1-102009 022 966
- US-A1- 2007 295 968
- US-B1- 6 744 196

## Beschreibung

Die Erfindung betrifft einen optoelektronischen Halbleiterchip.

Diese Patentanmeldung beansprucht die Priorität der deutschen Patentanmeldung 10 2011 016 302. 6.

Aus der Druckschrift WO 2009/106069 A1 ist ein optoelektronischer Halbleiterchip bekannt, bei dem eine erste und eine zweite elektrische Kontaktschicht zwischen der Halbleiterschichtenfolge und dem Trägersubstrat angeordnet sind. Die erste und die zweite elektrische Kontaktschicht sind dabei mittels einer elektrisch isolierenden Schicht voneinander isoliert. Bei einem derartigen Halbleiterchip kann eine Spiegelschicht an einer dem Trägersubstrat zugewandten Seite an die Halbleiterschichtenfolge angrenzen, um die von der aktiven Zone in Richtung des Trägersubstrats emittierte Strahlung zu einer dem Trägersubstrat gegenüberliegenden Strahlungsauskoppelfläche umzulenken.

Die Druckschriften DE 10 2007 022 947 A1, DE 10 2009 022 966 A1 und DE 10 2008 030 584 A1 offenbaren ähnliche optoelektronische Halbleiterchips.

Bei einem derartigen Halbleiterchip kann die Gefahr bestehen, dass Feuchtigkeit von den Rändern des Halbleiterchips her durch die elektrisch isolierende Schicht bis in den Bereich der Spiegelschicht transportiert wird, was eine Degradation der Spiegelschicht und somit eine Verringerung der Strahlungsausbeute zur Folge hätte.

Der Erfindung liegt die Aufgabe zugrunde, einen verbesserten optoelektronischen Halbleiterchip anzugeben, bei dem die Spiegelschicht effektiv vor dem Eindringen von Feuchtigkeit geschützt ist und gleichzeitig eine effiziente elektrische Kontaktierung des Halbleiterchips mit verhältnismäßig geringem Herstellungsaufwand erzielt wird.

Diese Aufgabe wird durch einen optoelektronischen Halbleiterchip mit den Merkmalen des Patentanspruchs 1 gelöst. Vorteilhafte Ausgestaltungen und Weiterbildungen der Erfindung sind Gegenstand der abhängigen Ansprüche.

Gemäß der vorliegenden Erfindung umfasst der optoelektronische Halbleiterchip eine Halbleiterschichtenfolge, die einen ersten Halbleiterbereich eines ersten Leitungstyps, einen zweiten Halbleiterbereich eines zweiten Leitungstyps und eine zwischen dem ersten und dem zweiten Halbleiterbereich angeordnete aktive Zone aufweist.

Weiterhin umfasst der optoelektronische Halbleiterchip ein Trägersubstrat, wobei die Halbleiterschichtenfolge eine dem Trägersubstrat zugewandte erste Hauptfläche und eine gegenüberliegende zweite Hauptfläche aufweist. Eine erste elektrische Kontaktschicht und eine zweite elektrische Kontaktschicht sind zumindest bereichsweise zwischen dem Trägersubstrat und der ersten Hauptfläche der Halbleiterschichtenfolge angeordnet, wobei die zweite elektrische Kontaktschicht durch einen Durchbruch in dem ersten Halbleiterbereich und der aktiven Zone in den zweiten Halbleiterbereich geführt ist. Die erste und die zweite elektrische Kontaktschicht sind durch eine elektrisch isolierende Schicht voneinander isoliert.

Zwischen der Halbleiterschichtenfolge und dem Trägersubstrat ist eine Spiegelschicht angeordnet. Die Spiegelschicht kann insbesondere an der ersten Hauptfläche an die Halbleiterschichtenfolge angrenzen. Durch die Spiegelschicht wird vorteilhaft Strahlung, die von der aktiven Zone in Richtung des Trägersubstrats emittiert wird, zu der als Strahlungsauskoppelfläche dienenden zweiten Hauptfläche der Halbleiterschichtenfolge reflektiert. Die Spiegelschicht grenzt insbesondere an Teilbereiche der ersten elektrischen Kontaktschicht und an Teilbereiche der elektrisch isolierenden Schicht an, wobei die dem Trägersubstrat zugewandte Grenzfläche der Spiegelschicht von der ersten elektrischen Kontaktschicht bedeckt ist.

Der optoelektronische Halbleiterchip gemäß der vorliegenden Erfindung umfasst eine transparente Verkapselungsschicht, welche Seitenflächen der Halbleiterschichtenfolge, Seitenflächen der Spiegelschicht und Seitenflächen der elektrisch isolierenden Schicht, die den Seitenflächen des Halbleiterchips zugewandt sind, bedeckt. Weiterhin bedeckt die transparente Verkapselungsschicht vollständig die Halbleiterschichtenfolge. Die Seitenflächen der Spiegelschicht sind außerdem allseitig von der transparenten Verkapselungsschicht umgeben.

Dadurch, dass die transparente Verkapselungsschicht die Seitenflächen der Halbleiterschichtenfolge und der Spiegelschicht bedeckt, wird die Spiegelschicht vor dem Eindringen von Feuchtigkeit geschützt. Diese Schutzwirkung der transparenten Verkapselungsschicht wird dadurch weiter verbessert, dass die transparente Verkapselungsschicht auch die den Seitenflächen des Halbleiterchips zugewandten Seitenflächen der elektrisch isolierenden Schicht bedeckt. Auf diese Weise wird insbesondere eine Eindringen von Feuchtigkeit in die elektrisch isolierende Schicht verhindert und so das Risiko vermindert, dass sich Feuchtigkeit durch die elektrisch isolierende Schicht hindurch bis hin zur Spiegelschicht ausbreitet.

Vorzugsweise grenzt die elektrisch isolierende Schicht an keiner Stelle an ein Umgebungsmedium des optoelektronischen Halbleiterchips an. So wird vorteilhaft sichergestellt, dass Feuchtigkeit nicht von außen in die elektrisch isolierende Schicht eindringen und sich im Schichtsystem des Halbleiterchips ausbreiten kann.

Die transparente Verkapselungsschicht enthält vorzugsweise ein Aluminiumoxid wie beispielsweise Al₂O₃ oder ein Siliziumoxid wie beispielsweise SiO₂, oder besteht daraus.

Besonders bevorzugt weist die transparente Verkapselungsschicht eine AlD-Schicht auf, d.h. eine mittels Atomlagenabscheidung (ALD - Atomic Layer Deposition) hergestellte Schicht. Bei einer weiteren vorteilhaften Ausgestaltung weist die transparente Verkapselungsschicht ein Spin-on-Glas auf. Eine ALD-Schicht oder ein Spin-on-Glas zeichnen sich vorteilhaft durch eine geringe Defektdichte aus und bieten einen guten Schutz gegen das Eindringen von Feuchtigkeit. Das Aufbringen der transparenten Verkapselungsschicht mittels ALD oder als Spin-On-Glas hat weiterhin den Vorteil, dass die transparente Verkapselungssicht in kleine Zwischenräume eingebracht werden kann.

Insbesondere ist es vorteilhaft, wenn die Spiegelschicht eine kleinere laterale Ausdehnung als die Halbleiterschichtenfolge aufweist, und sich Teilbereiche der transparenten Verkapselungsschicht unter die Halbleiterschichtenfolge erstrecken. Auf diese Weise wird ein besonders guter Schutz der Spiegelschicht vor Oxidation und/oder dem Eindringen von Feuchtigkeit erzielt. Vorzugsweise weist die Halbleiterschichtenfolge an allen Seitenflächen einen Überstand über die Spiegelschicht auf. An die Seitenflächen der Spiegelschicht grenzt vorteilhaft ein Zwischenraum an, der zwischen der Halbleiterschichtenfolge und einer auf das Trägersubstrat aufgebrachten Schichtenfolge ausgebildet ist. Dieser Zwischenraum wird vorteilhaft von der transparenten Verkapselungsschicht aufgefüllt.

Gemäß der vorliegenden Erfindung ist die zweite Hauptfläche der Halbleiterschichtenfolge, die insbesondere als Strahlungsaustrittsfläche dient, vollständig von der transparenten Verkapselungsschicht bedeckt.

Die Halbleiterschichtenfolge ist vollständig, d.h. einschließlich der Seitenflächen, von der transparenten Verkapselungsschicht bedeckt.

Bei einer vorteilhaften Ausgestaltung weist die Halbleiterschichtenfolge eine Mesastruktur auf, wobei sich die erste und die zweite elektrische Kontaktschicht bis in seitlich neben der Mesastruktur angeordnete Bereiche des Halbleiterchips erstrecken.

Die transparente Verkapselungsschicht weist vorzugsweise neben der Mesastruktur eine Öffnung auf, in der ein Anschlusskontakt für die erste elektrische Kontaktschicht angeordnet ist. Der Anschlusskontakt ist in diesem Fall vorteilhaft neben der Halbleiterschichtenfolge angeordnet, so dass insbesondere eine als Strahlungsaustrittsfläche fungierende zweite Hauptfläche der Halbleiterschichtenfolge frei von Anschlusskontakten ist. Dies hat den Vorteil, dass die Strahlungsaustrittsfläche nicht von dem Anschlusskontakt abgeschattet wird und sich somit die Effizienz des Halbleiterchips erhöht. Der Anschlusskontakt ist vorzugsweise außerhalb der Mitte des Halbleiterchips, insbesondere in einer Ecke des Halbleiterchips, angeordnet.

Die erste elektrische Kontaktschicht dient vorteilhaft zum einen zur elektrischen Kontaktierung des Halbleiterchips und zum anderen zum Schutz der Spiegelschicht vor Korrosion. Insbesondere wird zumindest ein Teil der dem Trägersubstrat zugewandten Grenzfläche der Spiegelschicht von der ersten elektrischen Kontaktschicht bedeckt.

Die erste elektrische Kontaktschicht enthält vorzugsweise Gold, Titan, Chrom, Platin, Titannitrid, Titanwolframnitrid oder Nickel oder besteht daraus. Diese Materialien zeichnen sich vorteilhaft zum einen durch eine gute elektrische Leitfähigkeit und zum anderen durch ihre Eignung als Diffusionsbarriere aus. Die erste elektrische Kontaktschicht kann mehrere Teilschichten aufweisen, die vorzugsweise jeweils mindestens eines dieser Materialien enthalten.

Die Spiegelschicht enthält vorzugsweise Silber, Aluminium oder eine Silber- oder Aluminiumlegierung oder besteht daraus. Silber und Aluminium zeichnen sich durch eine hohe Reflexion im sichtbaren Spektralbereich aus. Weiterhin haben diese Materialien eine gute elektrische Leitfähigkeit und bilden einen Metall-Halbleiterkontakt mit geringem Kontaktwiderstand aus. Dies ist vorteilhaft, da die Spiegelschicht vorteilhaft an die Halbleiterschichtenfolge angrenzt und auf diese Weise den ersten Halbleiterbereich mit der ersten elektrischen Kontaktschicht elektrisch leitend verbindet.

Die zweite elektrische Kontaktschicht enthält wie die Spiegelschicht vorzugsweise Silber, Aluminium oder eine oder eine Silber- oder Aluminiumlegierung, oder besteht daraus. Eine hohe Reflexion im sichtbaren Spektralbereich und eine gute elektrische Leitfähigkeit sind für die zweite elektrische Kontaktschicht vorteilhaft, da auch die zweite elektrische Kontaktschicht zumindest bereichsweise an die Halbleiterschichtenfolge angrenzt und auf diese Weise den zweiten Halbleiterbereich elektrisch kontaktiert.

Die elektrisch isolierende Schicht, welche die erste elektrische Kontaktschicht und die zweite elektrische Kontaktschicht voneinander isoliert, enthält vorzugsweise ein Siliziumoxid, ein Siliziumnitrid, ein Siliziumoxinitrid oder ein Aluminiumoxid.

Bei einer bevorzugten Ausführungsform ist der erste Halbleiterbereich ein p-Typ-Halbleiterbereich und der zweite Halbleiterbereich ein n-Typ-Halbleiterbereich. Die Spiegelschicht grenzt bei dieser Ausgestaltung also an den p-Typ-Halbleiterbereich an, und die zweite elektrische Kontaktschicht ist durch den Durchbruch in den n-Typ-Halbleiterbereich hineingeführt. Der p-Typ-Halbleiterbereich ist dem Trägersubstrat und der n-Typ-Halbleiterbereich der als Strahlungsaustrittsfläche dienenden zweiten Hauptfläche der Halbleiterschichtenfolge zugewandt.

Bei einer weiteren vorteilhaften Ausgestaltung weist die Halbleiterschichtenfolge des optoelektronischen Halbleiterchips kein Aufwachssubstrat auf. In diesem Fall handelt es sich bei dem Halbleiterchip um einen so genannten Dünnfilm-Leuchtdiodenchip, bei dem das zum epitaktischen Aufwachsen der Halbleiterschichtenfolge verwendete Aufwachssubstrat nach dem Verbinden der Halbleiterschichtenfolge mit dem Trägersubstrat abgelöst wurde.

Der Halbleiterchip ist vorzugsweise mittels einer Lotschicht mit dem Trägersubstrat verbunden. Insbesondere kann der Halbleiterchip an der dem ursprünglichen Aufwachssubstrat gegenüberliegenden Seite mit dem Trägersubstrat verbunden sein.

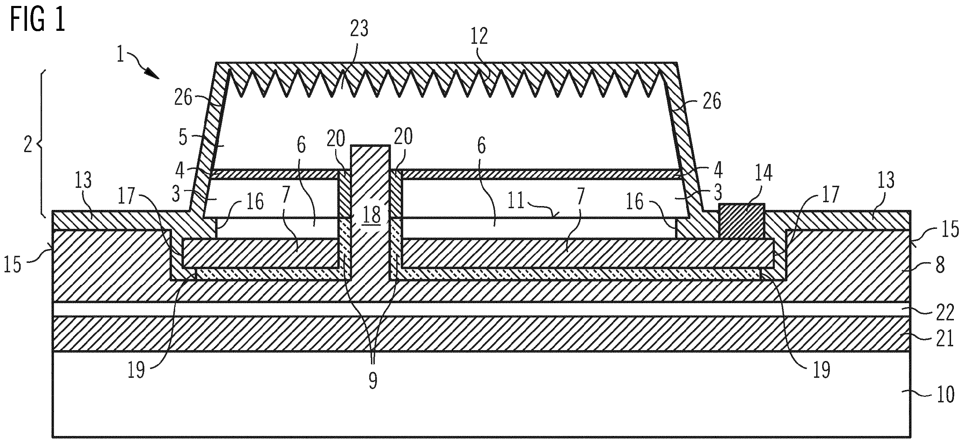

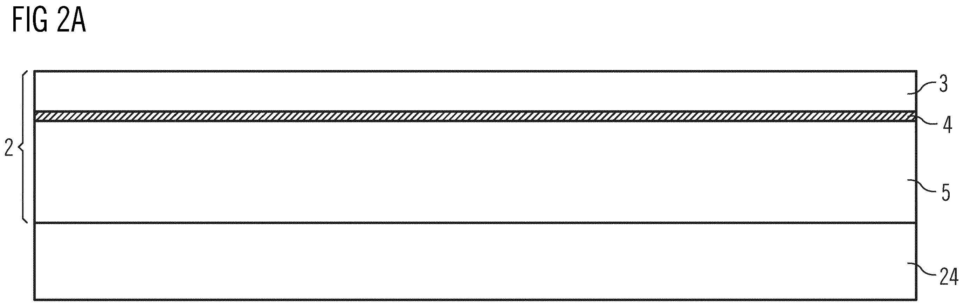

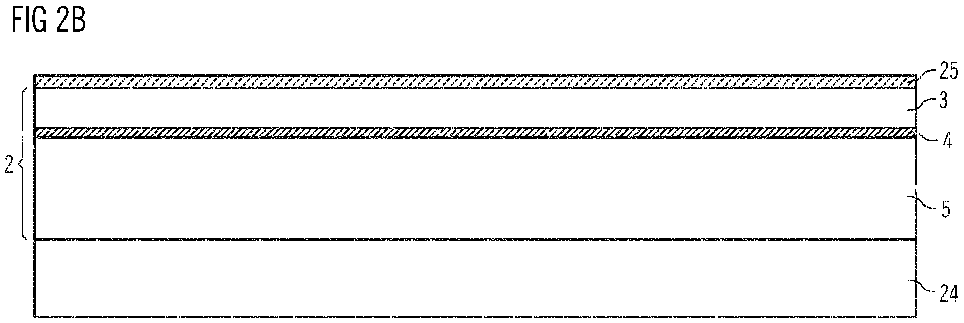

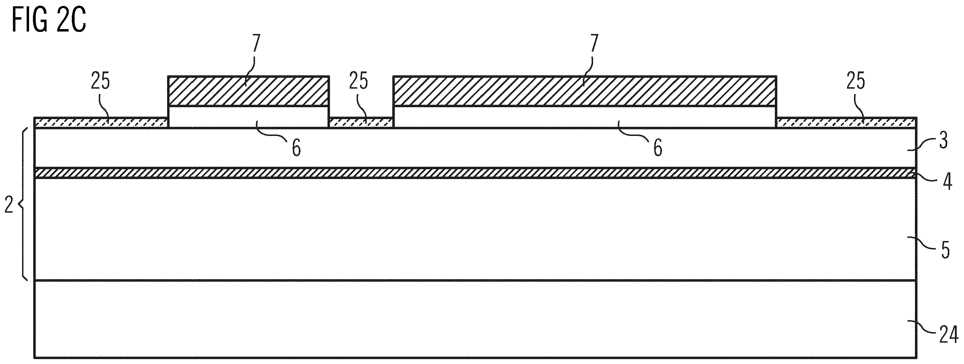

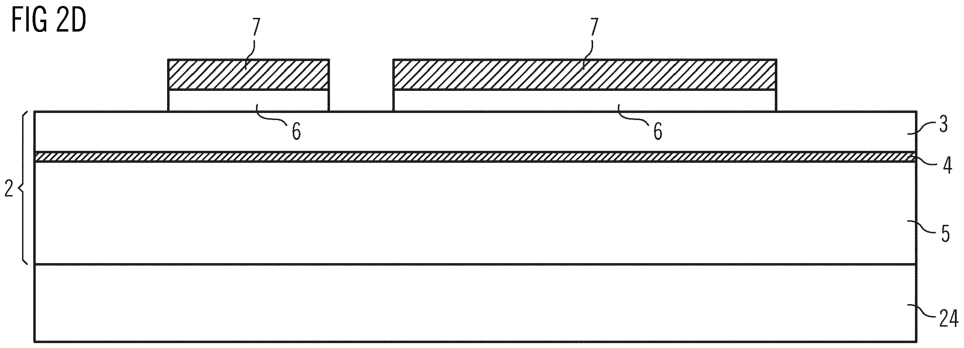

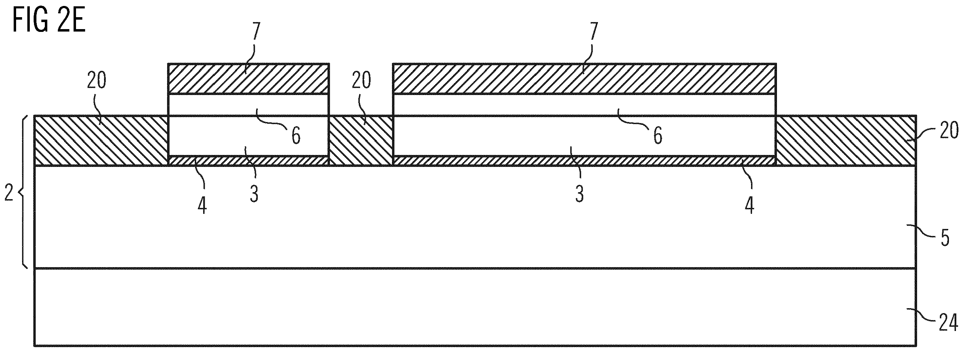

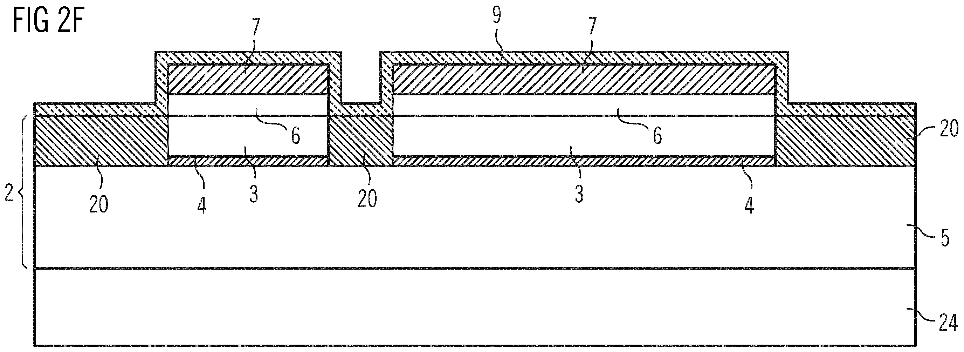

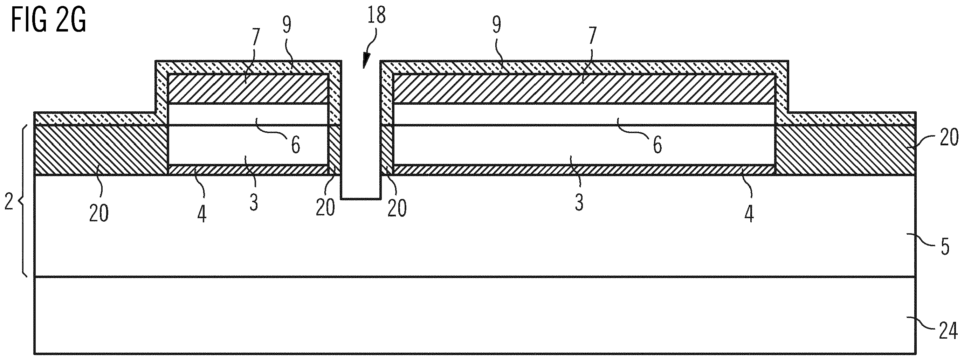

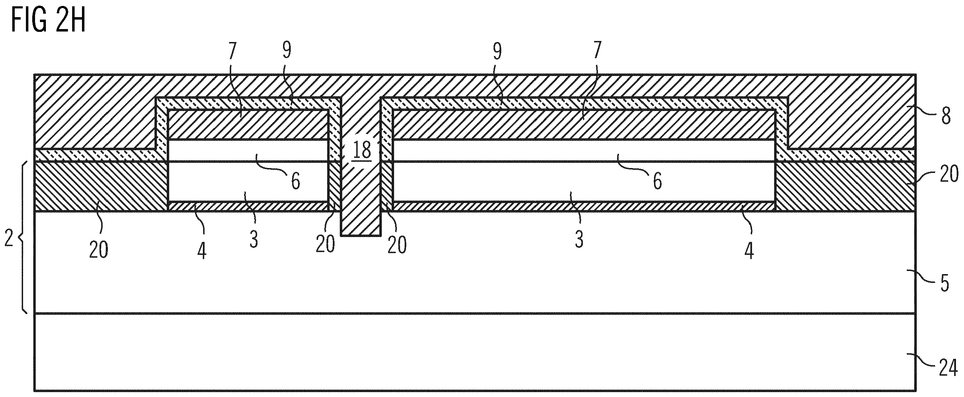

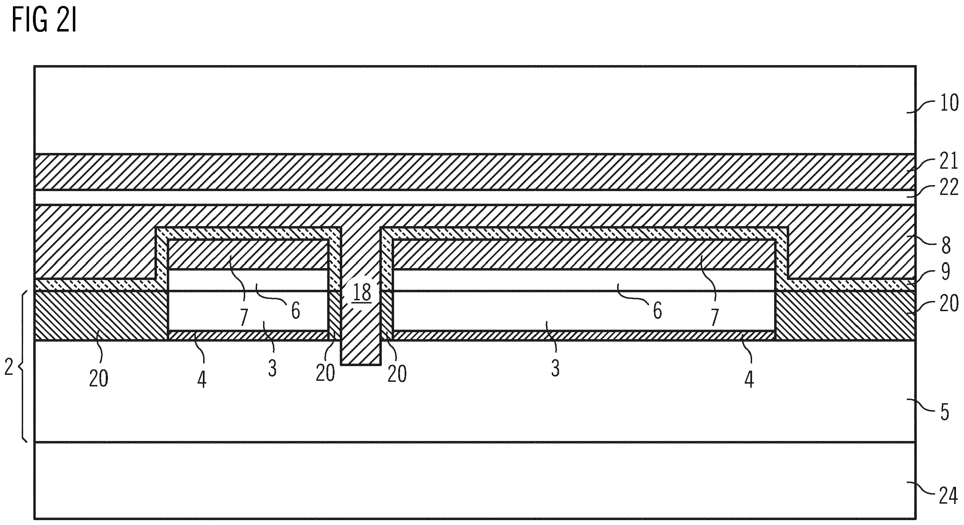

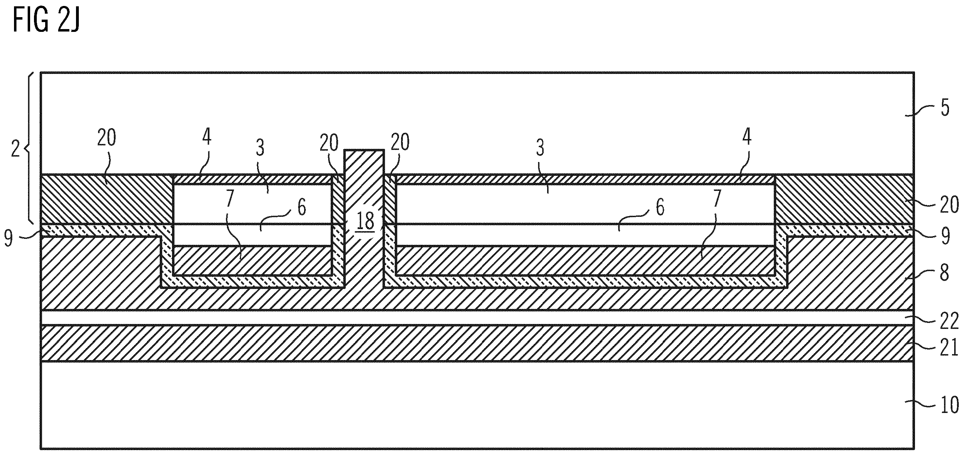

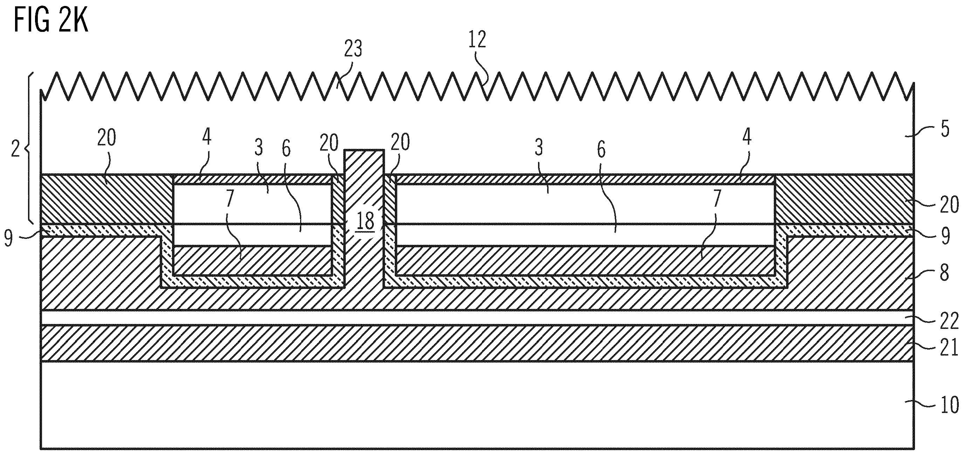

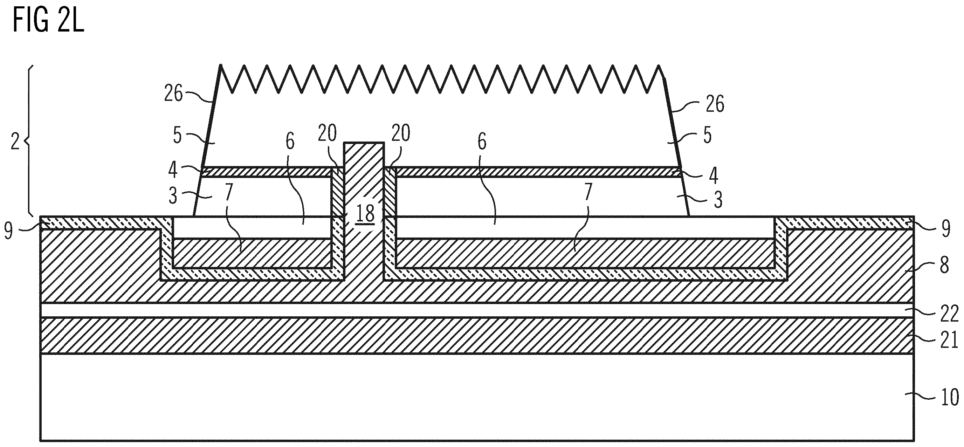

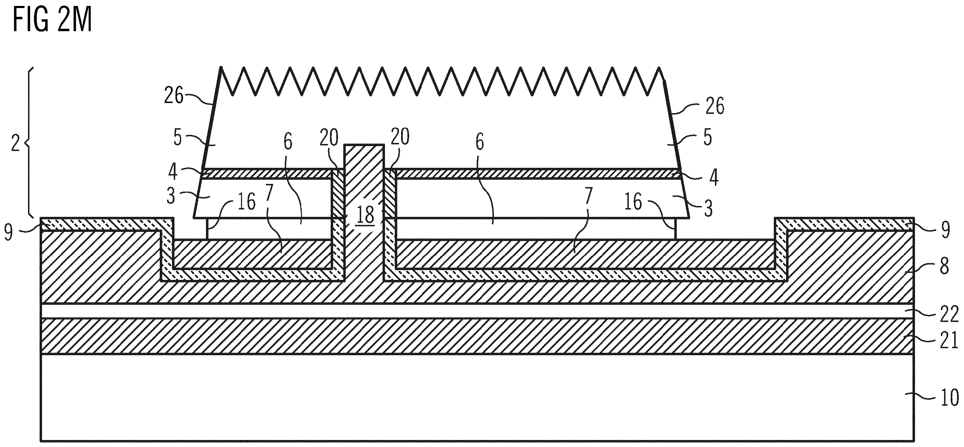

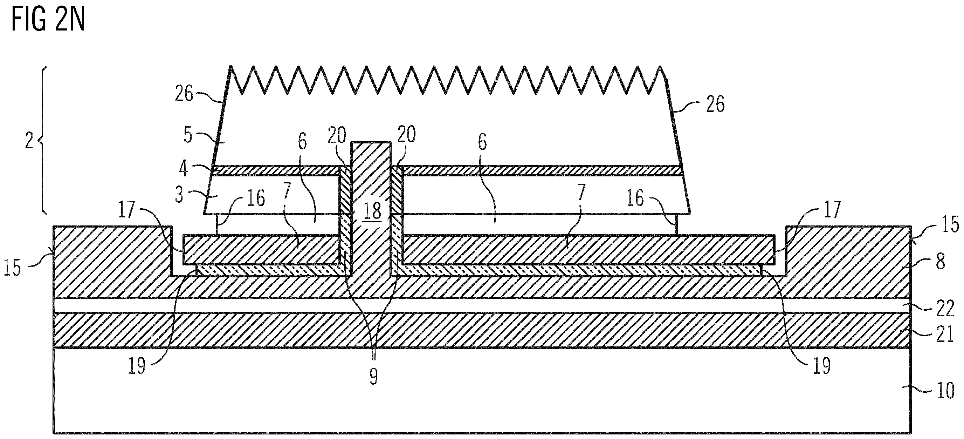

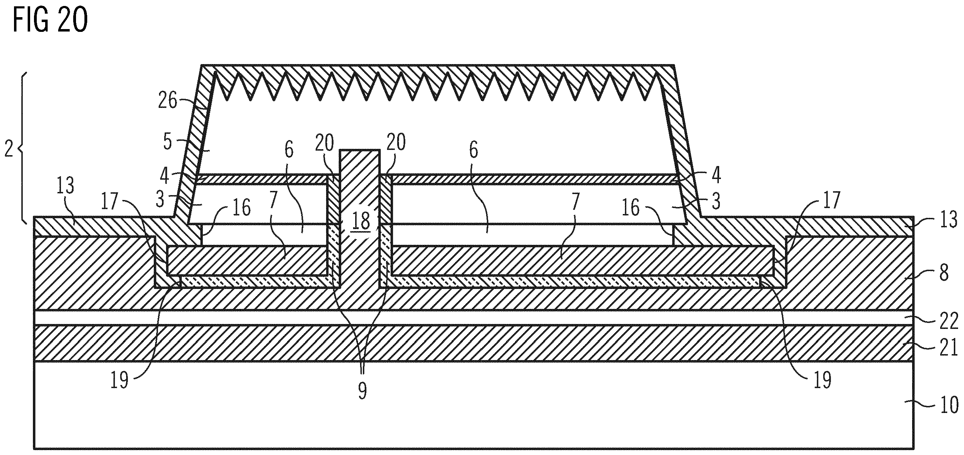

Die Erfindung wird im Folgenden anhand eines Ausführungsbeispiels im Zusammenhang mit den Figuren 1 und 2 näher erläutert.

Es zeigen:
Figur 1 eine schematische Darstellung eines Querschnitts durch einen optoelektronischen Halbleiterchip gemäß einem Ausführungsbeispiel, und
Figuren 2A bis 2O eine schematische Darstellung eines Verfahrens zur Herstellung des in Figur 1 dargestellten optoelektronischen Halbleiterchips anhand von Zwischenschritten.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

Der in Figur 1 schematisch im Querschnitt dargestellte optoelektronische Halbleiterchip 1 enthält eine Halbleiterschichtenfolge 2, die einen ersten Halbleiterbereich 3 eines ersten Leitungstyps und einen zweiten Halbleiterbereich 5 eines zweiten Leitungstyps aufweist. Vorzugsweise ist der erste Halbleiterbereich 3 ein p-Typ-Halbleiterbereich und der zweite Halbleiterbereich 5 ein n-Typ-Halbleiterbereich. Zwischen dem ersten Halbleiterbereich 3 und dem zweiten Halbleiterbereich 5 ist eine aktive Zone 4 angeordnet.

Die aktive Zone 4 des optoelektronischen Halbleiterchips 1 kann insbesondere eine zur Emission von Strahlung geeignete aktive Zone sein. In diesem Fall handelt es sich bei dem optoelektronischen Halbleiterchip 1 um eine Lumineszenzdiode, insbesondere um eine LED. Alternativ wäre es auch denkbar, dass die aktive Zone 4 eine strahlungsdetektierende Schicht ist, wobei es sich bei dem optoelektronischen Halbleiterchip 1 in diesem Fall um ein Detektorbauelement handelt. Die aktive Zone 4 kann zum Beispiel als pn-Übergang, als Doppelheterostruktur, als Einfach-Quantentopfstruktur oder Mehrfach-Quantentopfstruktur ausgebildet sein.

Die Halbleiterschichtenfolge 2 des Halbleiterchips 1 basiert vorzugsweise auf einem III-V-Verbindungshalbleitermaterial, insbesondere auf einem Arsenid-, Nitrid- oder Phosphid-Verbindungshalbleitermaterial. Beispielsweise kann die Halbleiterschichtenfolge 2 InₓAl_{y}Ga_{1-x-y}N, InₓAl_{y}Ga_{1-x-y}P oder InₓAl_{y}Ga_{1-x-y}As, jeweils mit 0 ≤ x ≤ 1, 0 ≤ y ≤ 1 und x + y ≤ 1, enthalten. Dabei muss das III-V-Verbindungshalbleitermaterial nicht zwingend eine mathematisch exakte Zusammensetzung nach einer der obigen Formeln aufweisen. Vielmehr kann es einen oder mehrere Dotierstoffe sowie zusätzliche Bestandteile aufweisen, die die physikalischen Eigenschaften des Materials im wesentlichen nicht ändern. Der Einfachheit halber beinhalten obige Formeln jedoch nur die wesentlichen Bestandteile des Kristallgitters, auch wenn diese teilweise durch geringe Mengen weiterer Stoffe ersetzt sein können.

Der Halbleiterchip 1 ist mit einer Verbindungsschicht 21, bei der es sich insbesondere um eine Lotschicht aus einem Metall oder einer Metalllegierung handeln kann, mit einem Trägersubstrat 10 verbunden.

Zur elektrischen Kontaktierung weist der Halbleiterchip 1 eine erste elektrische Kontaktschicht 7 und eine zweite elektrische Kontaktschicht 8 auf. Die erste elektrische Kontaktschicht 7 ist mit dem ersten Halbleiterbereich 3 und die zweite elektrische Kontaktschicht 8 mit dem zweiten Halbleiterbereich 5 elektrisch leitend verbunden.

Sowohl die erste elektrische Kontaktschicht 7 als auch die zweite elektrische Kontaktschicht 8 sind zumindest bereichsweise zwischen einer dem Trägersubstrat 10 zugewandten ersten Hauptfläche 11 der Halbleiterschichtenfolge 2 und dem Trägersubstrat 10 angeordnet. Die erste elektrische Kontaktschicht 7 und die zweite elektrische Kontaktschicht 8 sind mittels einer elektrisch isolierenden Schicht 9 elektrisch voneinander isoliert. Die elektrisch isolierende Schicht 9 enthält vorzugsweise ein Siliziumoxid, ein Siliziumnitrid, ein Siliziumoxinitrid, ein Aluminiumoxid oder besteht daraus. Alternativ kann die elektrisch isolierende Schicht 9 auch andere Oxide oder Nitride enthalten.

Die dem Trägersubstrat 10 gegenüberliegende zweite Hauptfläche 12 der Halbleiterschichtenfolge 2 dient als Strahlungsauskoppelfläche des optoelektronischen Halbleiterchips 1 und ist vorteilhaft frei von elektrischen Kontaktschichten. Um die Strahlungsauskopplung zu verbessern, kann die zweite Hauptfläche 12 mit einer Auskoppelstruktur 23 oder einer Aufrauhung versehen sein.

Um die Strahlungsausbeute des optoelektronischen Halbleiterchips 1 zu verbessern, ist zwischen der Halbleiterschichtenfolge 2 und dem Trägersubstrat 10 eine Spiegelschicht 6 angeordnet. Die Spiegelschicht 6 ist dem ersten Halbleiterbereich 3 an der dem Trägersubstrat 10 zugewandten Seite nachgeordnet und kann insbesondere an die erste Hauptfläche 11 der Halbleiterschichtenfolge 2 angrenzen. Es ist auch möglich, dass zwischen dem ersten Halbleiterbereich 3 und der Spiegelschicht 6 eine Zwischenschicht angeordnet ist, beispielsweise eine dünne Haftvermittlerschicht. Die Spiegelschicht 6 enthält insbesondere Silber, Aluminium oder eine Metalllegierung mit Silber oder Aluminium. Diese Materialien zeichnen sich durch eine hohe Reflektivität im sichtbaren Spektralbereich und eine gute elektrische Leitfähigkeit aus. Die Spiegelschicht 6 hat zum einen die Funktion, von der aktiven Zone 4 in Richtung des Trägersubstrats 10 emittierte Strahlung zur Strahlungsauskoppelfläche 12 zu reflektieren. Weiterhin dient die Spiegelschicht 6 auch zur elektrischen Kontaktierung des ersten Halbleiterbereichs 3. Insbesondere grenzt die Spiegelschicht 6 an der dem Trägersubstrat 10 zugewandten Seite an die erste elektrische Kontaktschicht 7 an und ist somit mit der ersten elektrischen Kontaktschicht 7 elektrisch leitend verbunden.

Die erste elektrische Kontaktschicht 7 bedeckt vorzugsweise die dem Trägersubstrat 10 zugewandte Grenzfläche der Spiegelschicht. Die erste elektrische Kontaktschicht 7 enthält vorzugsweise Gold, Titan, Chrom, Platin, Titannitrid, Titanwolframnitrid oder Nickel oder besteht daraus. Diese Materialien zeichnen sich dadurch aus, dass sie elektrisch leitfähig und zudem chemisch inert sind. Auf diese Weise wird die Spiegelschicht 6 in den Bereichen, in denen sie von der ersten elektrischen Kontaktschicht 7 bedeckt ist, vorteilhaft vor Korrosion geschützt.

Die zweite elektrische Kontaktschicht 8 ist durch einen Durchbruch 18, der durch den ersten Halbleiterbereich 3 und die aktive Zone 4 hindurch verläuft, an den zweiten Halbleiterbereich 5 elektrisch leitend angeschlossen. Im Bereich des Durchbruchs 18 sind die aktive Zone 4, der erste Halbleiterbereich 3, die Spiegelschicht 6 und die erste elektrische Kontaktschicht 7 mittels der elektrisch isolierenden Schicht 9 oder passivierten Bereichen 20 der Halbleiterschichtenfolge 2 von der zweiten elektrischen Kontaktschicht 8 isoliert.

Die zweite elektrische Kontaktschicht 8 fungiert in den Bereichen, in denen sie direkt an die Halbleiterschichtenfolge 2 angrenzt, vorteilhaft nicht nur als Kontaktschicht, sondern auch als reflektierende Schicht, die Strahlung zur als Strahlungsaustrittsfläche dienenden zweiten Hauptfläche 12 der Halbleiterschichtenfolge 2 hin reflektiert. Die zweite elektrische Kontaktschicht 8 weist daher vorteilhaft ein Metall oder eine Metalllegierung mit einer hohen Reflektivität auf, insbesondere Silber, Aluminium oder eine Legierung mit Silber oder Aluminium.

Bei dem Halbleiterchip 1 sind die Seitenflächen 26 der Halbleiterschichtenfolge 2 und die Seitenflächen 16 der Spiegelschicht 6 von einer elektrisch isolierenden transparenten Verkapselungsschicht 13 bedeckt. Die Verkapselungsschicht 13 hat zum einen die Funktion, die Spiegelschicht 6 vor Korrosion zu schützen. Insbesondere wird die Spiegelschicht 6 durch die Verkapselungsschicht 13 vor Oxidation oder dem Eindringen von Feuchtigkeit geschützt. Die Seitenflächen 16 der Spiegelschicht 6 sind allseitig von der Verkapselungsschicht 13 umgeben, sodass die Spiegelschicht 6 an keiner Stelle direkt an das Umgebungsmedium angrenzt.

Die transparente Verkapselungsschicht 13 bedeckt weiterhin auch die Seitenflächen 17 der ersten Kontaktschicht 7 und die den Seitenflächen 15 des Halbleiterchips 1 zugewandten Seitenflächen 19 der elektrisch isolierenden Schicht 9. Auf diese Weise wird insbesondere ein Eindringen von Feuchtigkeit in die elektrisch isolierende Schicht 9 verhindert. Besonders bevorzugt grenzt die elektrisch isolierende Schicht 9 an keiner Stelle an ein Umgebungsmedium des Halbleiterchips 1 an.

Die transparente Verkapselungsschicht 13 ist vorzugsweise eine Aluminiumoxidschicht, insbesondere eine Al₂O₃-Schicht, oder eine Siliziumoxidschicht, insbesondere eine SiO₂-Schicht. Die transparente Verkapselungsschicht wird vorteilhaft mittels Atomlagenabscheidung oder als Spin-on-Glas abgeschieden. Eine solche mittels ALD oder als Spin-on-Glas abgeschiedene Siliziumoxidschicht weist vorteilhaft eine hohe Beständigkeit gegen Korrosion und das Eindringen von Feuchtigkeit auf.

Bei einer besonders bevorzugten Ausgestaltung weist die Spiegelschicht 6 eine kleinere laterale Ausdehnung als die Halbleiterschichtenfolge 2 auf, sodass sich Teilbereiche der transparenten Verkapselungsschicht 13 unter die Halbleiterschichtenfolge 2 erstrecken. Die Seitenflächen 16 der Spiegelschicht 6 sind bei dieser Ausgestaltung vorteilhaft von den Seitenflächen 26 der Halbleiterschichtenfolge 2 beabstandet. Der Abstand zwischen den Seitenflächen 26 der Halbleiterschichtenfolge 2 und den Seitenflächen 16 der Spiegelschicht 6 beträgt bevorzugt zwischen 0,5 µm und 5 µm, besonders bevorzugt etwa 3 µm. Auf diese Weise wird die Spiegelschicht 6 besonders effektiv geschützt. Insbesondere durch das Herstellen der transparenten Verkapselungsschicht 13 mittels Atomlagenabscheidung ist es möglich, die transparente Verkapselungsschicht 13 derart abzuscheiden, dass sie den Zwischenraum zwischen der Halbleiterschichtenfolge 2 und der Spiegelschicht 6 auffüllt.

Die transparente Verkapselungsschicht 13 bedeckt vorteilhaft auch die Seitenflächen 26 und die als Strahlungsaustrittsfläche dienende zweite Hauptfläche 12 der Halbleiterschichtenfolge 2. Die Halbleiterschichtenfolge 2 ist also vorteilhaft vollständig von der transparenten Verkapselungsschicht 13 bedeckt. Vorteilhaft können durch die transparente Verkapselungsschicht 13 eventuell an den Oberflächen der Halbleiterschichtenfolge 2 vorhandene feine Risse geschlossen werden. Die vollständige Verkapselung der Halbleiterschichenfolge 2 ist daher vorteilhaft für die Langzeitstabilität des Halbleiterchips.

Die Halbleiterschichtenfolge 2 weist eine Mesastruktur auf, wobei sich die erste elektrische Kontaktschicht 7 und die zweite elektrische Kontaktschicht 8 seitlich neben die Mesastruktur erstrecken. Die transparente Verkapselungsschicht 13 weist neben der Mesastruktur eine Öffnung auf, in der ein Anschlusskontakt 14 angeordnet ist, der mit der ersten elektrischen Kontaktschicht verbunden ist. Der Anschlusskontakt 14 kann insbesondere ein Bondpad sein, das zum Anschluss eines Bonddrahts vorgesehen ist.

Der Anschlusskontakt 14 ist vorzugsweise außerhalb der Mitte des Halbleiterchips 1 angeordnet, insbesondere im Bereich einer Ecke des Halbleiterchips 1.

Bei einer Betrachtung des Halbleiterchips 1 von oben ist durch die transparente Verkapselungsschicht 13 hindurch neben der als Mesa strukturierten Halbleiterschichtenfolge 2 vorteilhaft im wesentlichen nur die zweite elektrische Kontaktschicht 8 sichtbar, die vorteilhaft ein hoch reflektierendes Metall wie beispielsweise Ag oder Al enthält. Lediglich in einem kleinen Bereich um den Anschlusskontakt 14 sind Bereiche der ersten elektrischen Kontaktschicht 7 sichtbar, die ein geringer reflektierendes Material wie beispielsweise Platin enthalten kann.

Die zweite elektrische Kontaktschicht 8 ist beispielsweise über die Rückseite des Halbleiterchips 1, insbesondere über ein elektrisch leitfähiges Trägersubstrat 10 und die Lotschicht 21, von außen elektrisch anschließbar. Zwischen der Lotschicht 21 und der zweiten elektrischen Kontaktschicht 8 kann eine Barriereschicht 22 angeordnet sein, die insbesondere eine Diffusion von Bestandteilen der Lotschicht 21 in die zweite elektrische Kontaktschicht 8 und umgekehrt verhindert.

In den folgenden Figuren 2A bis 2O wird ein Ausführungsbeispiel eines Verfahrens zur Herstellung des optoelektronischen Halbleiterchips beschrieben. Die zuvor beschriebenen vorteilhaften Ausgestaltungen einzelner Bestandteile des optoelektronischen Halbleiterchips gelten in gleicher Weise für das im Folgenden beschriebene Verfahren und umgekehrt.

Bei dem in Figur 2A dargestellten Zwischenschritt des Verfahrens ist die Halbleiterschichtenfolge 2, die den ersten Halbleiterbereich 3, die aktive Zone 4 und den zweiten Halbleiterbereich 5 umfasst, auf ein Aufwachssubstrat 24 aufgewachsen worden. Das Aufwachsen erfolgt vorzugsweise epitaktisch, insbesondere mittels MOVPE. Die Halbleiterschichtenfolge 2 kann beispielsweise Nitridverbindungshalbleitermaterialien enthalten und das Aufwachsubstrat 24 ein Saphirsubstrat sein. Der erste Halbleiterbereich 3 ist vorzugsweise ein p-Typ-Halbleiterbereich und der zweite Halbleiterbereich 5 ist vorzugsweise ein n-Typ-Halbleiterbereich.

Bei dem in Figur 2B dargestellten Verfahrensschritt wurde eine Oxidschicht 25, beispielsweise eine Siliziumoxidschicht, auf den zweiten Halbleiterbereich 5 aufgebracht. Die Oxidschicht 25 dient zum Schutz des ersten Halbleiterbereichs 3 bei nachfolgenden Fotolithographie- und Ätzprozessen.

Beim dem in Figur 2C dargestellten Zwischenschritt wurde die Oxidschicht beispielsweise fotolithografisch strukturiert. Weiterhin wurden die Spiegelschicht 6 und die erste elektrische Kontaktschicht 7 aufgebracht und mittels Lift-Off-Technik von den noch mit der Oxidschicht 25 bedeckten Bereichen abgehoben. Vorteilhaft werden also die Spiegelschicht 6 und die erste elektrische Kontaktschicht im gleichen Verfahrensschritt strukturiert. Die Spiegelschicht 6 enthält insbesondere Silber, Aluminium oder eine Metalllegierung mit Silber oder Aluminium. Die erste elektrische Kontaktschicht 7 bedeckt die Oberfläche der Spiegelschicht 6 und stellt auf diese Weise zum einen den elektrischen Anschluss zum ersten Halbleiterbereich 3 her, und dient zum anderen als Verkapselung für das Material der Spiegelschicht 6. Die erste elektrische Kontaktschicht 7 kann insbesondere Gold, Titan, Chrom, Platin, Titannitrid, Titanwolframnitrid oder Nickel enthalten oder daraus bestehen. Es ist auch möglich, dass die erste elektrische Kontaktschicht 7 mehrere Teilschichten umfasst. Beispielsweise kann die erste elektrische Kontaktschicht 7 eine Ti/Pt/Au/Cr-Schichtenfolge aufweisen.

Bei dem in Figur 2D dargestellten Verfahrensschritt ist die zuvor aufgebrachte Oxidschicht wieder entfernt worden, beispielsweise durch Ätzen mittels gepufferter Flusssäure (BOE - Buffered Oxide Etch).

Bei dem in Figur 2E dargestellten Zwischenschritt ist der p-dotierte Halbleiterbereich 3 in Bereichen 20, die zwischen und außerhalb der von der Spiegelschicht 6 und der ersten elektrischen Kontaktschicht 7 bedeckten Bereichen der Halbleiterschichtenfolge 2 angeordnet sind, passiviert worden. Die passivierten Bereiche 20 können beispielsweise durch einen Beschuss des p-dotierten Halbleitermaterials 3 mit Argon-Ionen erzeugt werden. Vorzugsweise erstrecken sich die passivierten Bereiche 20 bis in die aktive Schicht 4 hinein, so dass der pn-Übergang durch die elektrisch isolierenden passivierten Bereiche 20 durchtrennt ist. Anstelle die Bereiche 20 zu passivieren, ist es alternativ auch möglich, diese durch Sputtern abzutragen.

Auf die auf diese Weise hergestellte Struktur wurde bei dem in Figur 2F dargestellten Zwischenschritt eine elektrisch isolierende Schicht 9 aufgebracht. Die elektrisch isolierende Schicht 9 kann insbesondere eine Siliziumoxid- oder eine Siliziumnitridschicht sein.

Beim dem in Figur 2G dargestellten Zwischenschritt wurde ein Durchbruch 18 in der elektrisch isolierenden Schicht 9 und der Halbleiterschichtenfolge 2 erzeugt. Der Durchbruch 18 wird beispielsweise mittels Fotolithografie und reaktivem Ionenätzen erzeugt. Der Durchbruch 18 erstreckt sich durch die passivierten Bereiche 20 des ersten Halbleiterbereichs 3 und der aktiven Schicht 4 bis in den zweiten Halbleiterbereich 5 hinein.

Bei dem in Figur 2H dargestellten Zwischenschritt wurde die gesamte zuvor hergestellte Schichtstruktur mit der zweiten elektrischen Kontaktschicht 8 überdeckt. Die zweite elektrische Kontaktschicht 8 enthält vorzugsweise Silber, Aluminium oder eine Legierung mit Silber oder Aluminium. Die zweite elektrische Kontaktschicht 8 dient zur elektrischen Kontaktierung des zweiten Halbleiterbereichs 5, der insbesondere ein n-Typ-Halbleiterbereich sein kann. Die zweite elektrische Kontaktschicht 8 erstreckt sich durch den Durchbruch 18 bis in den zweiten Halbleiterbereich 5 hinein.

Bei dem in Figur 2I dargestellten Zwischenschritt ist der Halbleiterchip an einer von dem Aufwachssubstrat 24 abgewandten Seite mittels einer Lotschicht 21 mit einem Trägersubstrat 10 verbunden worden. Vor dem Verbinden des Trägersubstrats 10 mit dem Halbleiterchip wird vorzugsweise eine Barriereschicht 22 auf die zweite elektrische Kontaktschicht 8 aufgebracht, um die vorzugsweise Silber oder Aluminium enthaltende zweite elektrische Kontaktschicht 8 vor einer Diffusion von Bestandteilen der Lotschicht 21 zu schützen. Die Lotschicht 21 kann insbesondere AuSn enthalten. Die Barriereschicht 22 kann beispielsweise TiWN enthalten.

Das Trägersubstrat 10 ist vorzugsweise ein elektrisch leitfähiges Substrat, beispielsweise ein dotierter Halbleiterwafer aus Silizium oder Germanium. Alternativ kann das Trägersubstrat 10 auch durch eine galvanisch abgeschiedene Metallschicht gebildet werden.

Bei dem in Figur 2J dargestellten Zwischenschritt ist das Aufwachssubstrat 24 von dem Halbleiterchip abgelöst worden. Der Halbleiterchip ist im Vergleich zu den vorherigen Figuren um 180° gedreht dargestellt, da nun das dem ursprünglichen Aufwachssubstrat gegenüberliegende Trägersubstrat 10 als alleiniger Träger des Halbleiterchips fungiert. Das Aufwachssubstrat, insbesondere ein Saphir-Substrat, kann zum Beispiel mittels eines Laser-Lift-Off-Prozesses von der Halbleiterschichtenfolge 2 abgelöst werden.

Die Hauptfläche 12 der Halbleiterschichtenfolge 2, von der das Aufwachssubstrat 24 abgelöst wurde, wurde bei dem in Figur 2K dargestellten Zwischenschritt mit einer Auskoppelstruktur 23 versehen, beispielsweise durch Ätzen mit KOH. Dies ist vorteilhaft, da die zweite Hauptfläche 12 der Halbleiterschichtenfolge 2 im fertigen optoelektronischen Halbleiterchip als Strahlungsauskoppelfläche dient.

Bei dem in Fig. 2L dargestellten Zwischenschritt wurde die Halbleiterschichtenfolge 2 mit einer Mesastruktur versehen. Die Halbleiterschichtenfolge 2 wurde dazu in den Randbereichen des Halbleiterchips vollständig abgetragen, um eine Halbleiterschichtenfolge 2 mit einer gewünschten Form und Größe herzustellen. Die Strukturierung erfolgt vorzugsweise fotolithografisch, wobei als Ätzmittel beispielsweise H₃PO₄ und als Maske SiO₂ verwendet werden kann. Insbesondere wurde die Halbleiterschichtenfolge 2 derart abgetragen, dass neben der Halbleiterschichtenfolge 2 ein Teil der Spiegelschicht 6 und der elektrisch isolierenden Schicht 9 freiliegen. Die mit der Mesastruktur versehene Halbleiterschichtenfolge 2 kann schräge Seitenflanken 26 aufweisen. Die erste elektrische Kontaktschicht 7 und die zweite elektrische Kontaktschicht 8 erstrecken sich bis in seitlich neben der Mesastruktur liegende Bereiche des Halbleiterchips.

Bei dem in Fig. 2M dargestellten Verfahrensschritt wurde ein Teil der Spiegelschicht 6 mit einem zum selektiven Ätzen der Spiegelschicht 6 geeigneten Ätzmittel abgetragen. Die Halbleiterschichtenfolge 2 und die elektrisch isolierende Schicht 9 fungieren dabei als Ätzmaske. Die Halbleiterschichtenfolge wird bei dem Ätzprozess vorteilhaft unterätzt, so dass sich ein Zwischenraum zwischen der Halbleiterschichtenfolge 2 und der ersten elektrischen Kontaktschicht 7 ausbildet. Die Spiegelschicht 6 weist also eine kleinere laterale Ausdehnung als die angrenzende Halbleiterschichtenfolge 2 auf. Insbesondere weisen die Seitenflanken 16 der Spiegelschicht 6 einen Abstand zu den Seitenflanken 26 der Halbleiterschichtenfolge 2 auf. Der Abstand beträgt vorzugsweise zwischen 0,5 µm und 5 µm.

Bei dem in Figur 2N dargestellten Zwischenschritt wurden die nicht von der ersten elektrischen Kontaktschicht 7 bedeckten Bereiche der elektrisch isolierenden Schicht 9 entfernt. Dies kann beispielsweise durch Ätzen mittels gepufferter Flusssäure erfolgen. Auf diese Weise wird insbesondere erreicht, dass sich die elektrische isolierende Schicht 9 nicht mehr bis zu den Seitenflächen 15 des Halbleiterchips erstreckt. Durch den Ätzprozess werden die zuvor mit der elektrisch isolierenden Schicht 9 bedeckten Seitenflächen 17 der ersten elektrischen Kontaktschicht 7 freigelegt. Weiterhin werden unterhalb der ersten elektrischen Kontaktschicht 7 freiliegende Seitenflächen 19 der elektrisch isolierenden Schicht 9 erzeugt. Die erste elektrische Kontaktschicht 7 wird dabei vorzugsweise teilweise unterätzt, so dass die Seitenflächen 19 der elektrisch isolierenden Schicht 9 von den Seitenflächen 17 der ersten elektrischen Kontaktschicht 7 lateral beabstandet sind.

Auf die auf diese Weise hergestellte Schichtstruktur ist bei dem in Figur 2O dargestellten Zwischenschritt eine elektrisch isolierende transparente Verkapselungsschicht 13 aufgebracht worden. Die transparente Verkapselungsschicht 13 enthält bevorzugt Al₂O₃ oder SiO₂ oder besteht daraus. Die transparente Verkapselungsschicht 13 wird vorzugsweise zumindest teilweise mittels Atomlagenabscheidung (ALD - Atomic Layer Deposition) hergestellt. Alternativ kann die transparente Verkapselungsschicht 13 zumindest teilweise als Spin-On-Glas aufgebracht werden. Mit diesen Verfahren zur Schichtabscheidung können vorteilhaft besonders reine und dichte Schichten abgeschieden werden. Weiterhin haben diese Verfahren den Vorteil, dass eine Schichtabscheidung auch in vergleichsweise kleinen Zwischenräumen möglich ist. Insbesondere wird die transparente Verkapselungsschicht 13 derart abgeschieden, dass sie die an die Seitenflächen 16 der Spiegelschicht 6 und die Seitenflächen 19 der elektrisch isolierenden Schicht 9 angrenzenden Zwischenräume vollständig ausfüllt.

Es ist möglich, dass zunächst eine erste Teilschicht der transparenten Verkapselungsschicht 13 mittels Atomlagenabscheidung oder als Spin-on-Glas aufgebracht wird, um die in der Schichtstruktur erzeugten Hohlräume aufzufüllen. Die auf diese Weise hergestellte erste Teilschicht kann nachfolgend durch eine beispielsweise mittels CVD aufgebrachte zweite Teilschicht verstärkt werden. Die transparente Verkapselungsschicht 13 bedeckt die Halbleiterschichtenfolge 2 vorteilhaft vollständig, d.h. sowohl die Seitenflächen 26 als auch die als Strahlungsaustrittsfläche dienende zweite Hauptfläche 12. Es hat sich herausgestellt, dass durch die transparente Verkapselungsschicht 13 eventuell an den Oberflächen der Halbleiterschichtenfolge 2 vorhandene feine Risse geschlossen werden können, so dass die Gefahr von Korrosion oder des Eindringens von Feuchtigkeit vermindert wird.

Um den in Figur 1 dargestellten optoelektronischen Halbleiterchip 1 fertig zu stellen, wird nachfolgend neben der als Mesa strukturierten Halbleiterschichtenfolge 2 eine Öffnung in der transparenten Verkapselungsschicht 13 erzeugt, in der die erste elektrische Kontaktschicht 7 freigelegt wird. Die Herstellung der Öffnung erfolgt beispielsweise durch Fotolithografie und reaktives Ionenätzen. In dieser Öffnung wird ein Anschlusskontakt 14 aufgebracht. Der Anschlusskontakt 14 kann beispielsweise Gold und/oder Platin enthalten. Der Anschlusskontakt 14 kann insbesondere ein Bondpad sein, das zum Anschluss eines Bonddrahts vorgesehen ist. Der Anschlusskontakt 14 ist vorzugsweise außerhalb der Mitte des Halbleiterchips 1, insbesondere im Bereich einer Ecke des Halbleiterchips 1, angeordnet. Ein weiterer elektrischer Anschluss für den Halbleiterchip 1 kann an der Rückseite des vorzugsweise elektrisch leitfähigen Trägersubstrats 10 vorgesehen sein, um auf diese Weise die zweite elektrische Kontaktschicht 8 elektrisch anzuschließen. Auf diese Weise wurde das in Figur 1 dargestellte Ausführungsbeispiel eines optoelektronischen Halbleiterchips 1 hergestellt. Das Herstellungsverfahren zeichnet sich insbesondere dadurch aus, das nur vier Fotolithografieschritte erforderlich sind, so dass der Herstellungsaufwand trotz der aufwändigen Verkapselung des Halbleiterchips verhältnismäßig gering ist.

Die Erfindung ist nicht durch die Beschreibung anhand der Ausführungsbeispiele beschränkt, sondern durch die beigefügten Ansprüche definiert.

## Patentansprüche

1. Optoelektronischer Halbleiterchip (1), umfassend:
- eine Halbleiterschichtenfolge (2), die einen ersten Halbleiterbereich (3) eines ersten Leitungstyps, einen zweiten Halbleiterbereich (5) eines zweiten Leitungstyps und eine zwischen dem ersten (3) und dem zweiten Halbleiterbereich (5) angeordnete aktive Zone (4) aufweist,
- ein Trägersubstrat (10), wobei die Halbleiterschichtenfolge (2) eine dem Trägersubstrat (10) zugewandte erste Hauptfläche (11) und eine gegenüberliegende zweite Hauptfläche (12) aufweist,
- eine erste elektrische Kontaktschicht (7) und eine zweite elektrische Kontaktschicht (8), die zumindest bereichsweise zwischen dem Trägersubstrat (10) und der ersten Hauptfläche (11) der Halbleiterschichtenfolge (2) angeordnet sind, wobei die zweite elektrische Kontaktschicht (8) durch einen Durchbruch (18) in dem ersten Halbleiterbereich (3) und der aktiven Zone (4) in den zweiten Halbleiterbereich (5) geführt ist,
- eine elektrisch isolierende Schicht (9), die die erste elektrische Kontaktschicht (7) und die zweite elektrische Kontaktschicht (8) elektrisch voneinander isoliert,
- eine Spiegelschicht (6), die zwischen der Halbleiterschichtenfolge (2) und dem Trägersubstrat (10) angeordnet ist, und
- eine transparente Verkapselungsschicht (13), welche Seitenflächen (26) der Halbleiterschichtenfolge (2), Seitenflächen (16) der Spiegelschicht (6) und Seitenflächen (19) der elektrisch isolierenden Schicht (9), die den Seitenflächen (15) des Halbleiterchips (1) zugewandt sind, bedeckt,
wobei die Seitenflächen (16) der Spiegelschicht (6) allseitig von der transparenten Verkapselungsschicht (13) umgeben sind und die Halbleiterschichtenfolge (2) vollständig von der transparenten Verkapselungsschicht (13) bedeckt ist.

2. Optoelektronischer Halbleiterchip nach Anspruch 1,
wobei die elektrisch isolierende Schicht (9) an keiner Stelle an ein Umgebungsmedium des optoelektronischen Halbleiterchips (1) angrenzt.

3. Optoelektronischer Halbleiterchip nach einem der vorhergehenden Ansprüche,
wobei die transparente Verkapselungsschicht (13) ein Aluminiumoxid oder ein Siliziumoxid enthält oder daraus besteht.

4. Optoelektronischer Halbleiterchip nach einem der vorhergehenden Ansprüche,
wobei die transparente Verkapselungsschicht (13) eine ALD-Schicht aufweist.

5. Optoelektronischer Halbleiterchip nach einem der vorhergehenden Ansprüche,
wobei die transparente Verkapselungsschicht (13) ein Spin-on-Glas aufweist.

6. Optoelektronischer Halbleiterchip nach einem der vorhergehenden Ansprüche,
wobei die Spiegelschicht (6) eine kleinere laterale Ausdehnung als die Halbleiterschichtenfolge (2) aufweist, und sich Teilbereiche der transparenten Verkapselungsschicht (13) unter die Halbleiterschichtenfolge (2) erstrecken.

7. Optoelektronischer Halbleiterchip nach einem der vorhergehenden Ansprüche,
wobei die zweite Hauptfläche (12) vollständig von der transparenten Verkapselungsschicht (13) bedeckt ist.

8. Optoelektronischer Halbleiterchip nach einem der vorhergehenden Ansprüche,
wobei die Halbleiterschichtenfolge (2) eine Mesastruktur aufweist und sich die erste (7) und zweite elektrische Kontaktschicht (8) bis in seitlich neben der Mesastruktur angeordnete Bereiche erstrecken.

9. Optoelektronischer Halbleiterchip nach Anspruch 8,
wobei die transparente Verkapselungsschicht (13) neben der Mesastruktur eine Öffnung aufweist, in der ein Anschlusskontakt (14) für die erste elektrische Kontaktschicht (7) angeordnet ist.

10. Optoelektronischer Halbleiterchip nach Anspruch 9,
wobei der Anschlusskontakt (14) außerhalb der Mitte des Halbleiterchips (1) angeordnet ist.

11. Optoelektronischer Halbleiterchip nach einem der vorhergehenden Ansprüche,
wobei die erste elektrische Kontaktschicht (7) Gold, Titan, Chrom, Platin, Titannitrid, Titanwolframnitrid oder Nickel enthält.

12. Optoelektronischer Halbleiterchip nach einem der vorhergehenden Ansprüche,
wobei die Spiegelschicht (6) Silber, Aluminium oder eine Silber- oder Aluminiumlegierung enthält.

13. Optoelektronischer Halbleiterchip nach einem der vorhergehenden Ansprüche,
wobei die zweite elektrische Kontaktschicht (8) Silber, Aluminium oder eine Silber- oder Aluminiumlegierung enthält.

14. Optoelektronischer Halbleiterchip nach einem der vorhergehenden Ansprüche,
wobei die elektrisch isolierende Schicht (9) ein Siliziumoxid, ein Siliziumnitrid, ein Siliziumoxinitrid oder ein Aluminiumoxid enthält.

## Claims

1. An optoelectronic semiconductor chip (1), comprising:
- a semiconductor layer sequence (2) having a first semiconductor region (3) of a first conduction type, a second semiconductor region (5) of a second conduction type, and an active zone (4) arranged between the first semiconductor region (3) and the second semiconductor region (5),
- a carrier substrate (10), wherein the semiconductor layer sequence (2) has a first main surface (11) facing the carrier substrate, and an opposite second main surface (12),
- a first electrical contact layer (7) and a second electrical contact layer (8), which are arranged at least regionally between the carrier substrate (10) and the first main surface (11) of the semiconductor layer sequence (2), wherein the second electrical contact layer (8) is led through a perforation (18) in the first semiconductor region (3) and the active zone (4) into the second semiconductor region (5),
- an electrically insulating layer (9), which electrically insulates the first electrical contact layer (7) and the second electrical contact layer (8) from one another,
- a mirror layer (6), which is arranged between the semiconductor layer sequence (2) and the carrier substrate (10), and
- a transparent encapsulation layer (13) which covers side surfaces (26) of the semiconductor layer sequence (2), side surfaces (16) of the mirror layer (6) and side surfaces (19) of the electrically insulating layer (9) which face the side surfaces (15) of the semiconductor chip (1), wherein the side surfaces of the mirror layer (6) are surrounded by the encapsulation layer (13) on all sides, and the semiconductor layer sequence is completely covered by the transparent encapsulation layer.

2. The optoelectronic semiconductor chip according to claim 1,
wherein the electrically insulating layer (9) at no point adjoins a surrounding medium of the optoelectronic semiconductor chip (1).

3. The optoelectronic semiconductor chip according to either of the preceding claims,
wherein the transparent encapsulation layer (13) contains an aluminum oxide or a silicon oxide or consists thereof.

4. The optoelectronic semiconductor chip according to any of the preceding claims,
wherein the transparent encapsulation layer (13) comprises an ALD layer.

5. The optoelectronic semiconductor chip according to any of the preceding claims,
wherein the transparent encapsulation layer (13) comprises a spin-on glass.

6. The optoelectronic semiconductor chip according to any of the preceding claims,
wherein the mirror layer (6) has a smaller lateral extent than the semiconductor layer sequence (2), and partial regions of the transparent encapsulation layer (13) extend below the semiconductor layer sequence (2).

7. The optoelectronic semiconductor chip according to any of the preceding claims,
wherein the second main surface (12) is completely covered by the transparent encapsulation layer (13) .

8. The optoelectronic semiconductor chip according to any of the preceding claims,
wherein the semiconductor layer sequence (2) has a mesa structure and the first electrical contact layer (7) and second electrical contact layer (8) extend right into regions arranged laterally alongside the mesa structure.

9. The optoelectronic semiconductor chip according to claim 8,
wherein the transparent encapsulation layer (13) has alongside the mesa structure an opening in which a connection contact (14) for the first electrical contact layer (7) is arranged.

10. The optoelectronic semiconductor chip according to claim 9,
wherein the connection contact (14) is arranged outside the center of the semiconductor chip (1).

11. The optoelectronic semiconductor chip according to any of the preceding claims,
wherein the the first electrical contact layer (7) contains gold, titanium, chromium, platinum, titanium nitride, titanium tungsten nitride or nickel.

12. The optoelectronic semiconductor chip according to any of the preceding claims,
wherein the mirror layer (6) contains silver, aluminum or a silver or aluminum alloy.

13. The optoelectronic semiconductor chip according to any of the preceding claims,
wherein the second electrical contact layer (8) contains silver, aluminum or a silver or aluminum alloy.

14. The optoelectronic semiconductor chip according to any of the preceding claims,
wherein the electrically insulating layer (9) contains a silicon oxide, a silicon nitride, a silicon oxynitride or an aluminum oxide.

## Revendications

1. Puce optoélectronique à semiconducteur (1), comprenant :
- une succession de couches semiconductrices (2), qui présente une première zone de semiconducteurs (3) d'un premier type de conduite, une seconde zone de semiconducteurs (5) d'un second type de conduite et une zone active disposée entre la première (3) et la seconde zone de semiconducteurs (5),
- un substrat porteur (10), sachant que la succession de couches semiconductrices (2) présente une première surface principale (11) tournée vers le substrat porteur (10) et une seconde surface principale (12) située en face,
- une première couche de contact électrique (7) et une seconde couche de contact électrique (8), qui sont disposées au moins par zones entre le substrat porteur (10) et la première surface principale (11) de la succession de couches semiconductrices (2), sachant que la seconde couche de contact électrique (8) est conduite à travers une percée (18) dans la première zone de semiconducteurs (3) et la zone active (4) dans la seconde zone de semiconducteurs (5),
- une couche électriquement isolante (9), qui isole électriquement la première couche de contact électrique (7) et la seconde couche de contact électrique (8) l'une de l'autre,
- une couche réfléchissante (6), qui est disposée entre la succession de couches semiconductrices (2) et le substrat porteur (10), et
- une couche de blindage transparente (13), qui recouvre des surfaces latérales (26) de la succession de couches semiconductrices (2), des surfaces latérales (16) de la couche réfléchissante (6) et des surfaces latérales (19) de la couche électriquement isolante (9), qui sont tournées vers les surfaces latérales (15) de la puce à semiconducteur (1),
sachant que les surfaces latérales (16) de la couche réfléchissante (6) sont entourées sur tous les côtés de la couche de blindage transparente (13) et que la succession de couches semiconductrices (2) est recouverte entièrement de la couche de blindage transparente (13).

2. Puce optoélectronique à semiconducteur selon la revendication 1,
sachant que la couche électriquement isolante (9) n'est adjacente en aucun endroit à un milieu ambiant de la puce optoélectronique à semiconducteur (1).

3. Puce optoélectronique à semiconducteur selon une quelconque des revendications précédentes,
sachant que la couche de blindage transparente (13) contient un oxyde d'aluminium ou un oxyde de silicium ou en est constituée.

4. Puce optoélectronique à semiconducteur selon une quelconque des revendications précédentes,
sachant que la couche de blindage transparente (13) présente une couche ALD.

5. Puce optoélectronique à semiconducteur selon une quelconque des revendications précédentes,
sachant que la couche de blindage transparente (13) présente un verre déposé par centrifugation.

6. Puce optoélectronique à semiconducteur selon une quelconque des revendications précédentes,
sachant que la couche réfléchissante (6) présente une plus petite extension latérale que la succession de couches semiconductrices (2), et des zones partielles de la couche de blindage transparente (13) s'étendent au-dessous de la succession de couches semiconductrices (2).

7. Puce optoélectronique à semiconducteur selon une quelconque des revendications précédentes,
sachant que la seconde surface principale (12) est recouverte complètement par la couche de blindage transparente (13).

8. Puce optoélectronique à semiconducteur selon une quelconque des revendications précédentes,
sachant que la succession de couches semiconductrices (2) présente une structure mésa et que la première (7) et la seconde couches de contact électrique (8) s'étendent jusque dans les zones disposées latéralement à côté de la structure mésa.

9. Puce optoélectronique à semiconducteur selon la revendication 8,
sachant que la couche de blindage transparente (13) présente, outre la structure mésa, une ouverture, dans laquelle un contact de raccordement (14) est disposé pour la première couche de contact électrique (7).

10. Puce optoélectronique à semiconducteur selon la revendication 9,
sachant que le contact de connexion (14) est disposé en dehors du milieu de la puce à semiconducteur (1).

11. Puce optoélectronique à semiconducteur selon une quelconque des revendications précédentes,
sachant que la première couche de contact électrique (7) contient de l'or, du titane, du chrome, du platine, du nitrure de titane, du nitrure de titane-tungstène ou du nickel.

12. Puce optoélectronique à semiconducteur selon une quelconque des revendications précédentes,
sachant que la couche réfléchissante (6) contient de l'argent, de l'aluminium ou un alliage d'argent ou d'aluminium.

13. Puce optoélectronique à semiconducteur selon une quelconque des revendications précédentes,
sachant que la seconde couche de contact électrique (8) contient de l'argent, de l'aluminium ou un alliage d'argent ou d'aluminium.

14. Puce optoélectronique à semiconducteur selon une quelconque des revendications précédentes,
sachant que la couche électriquement isolante (9) contient un oxyde de silicium, un nitrure de silicium, un oxynitrure de silicium ou un oxyde d'aluminium.
